(19) Europäisches Patentamt / European Patent Office / Office européen des brevets

(11) **EP 2 288 028 A1**

(12) **EUROPEAN PATENT APPLICATION**

(43) Date of publication:
23.02.2011 Bulletin 2011/08

(51) Int Cl.:
*H03K 17/16* (2006.01)     *H05B 33/08* (2006.01)

(21) Application number: 09010214.6

(22) Date of filing: 07.08.2009

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Phihong Technology Co., Ltd.**
**Gueishan Township**
**T'ao yuan 333 (TW)**

(72) Inventors:
• **Chu, Chung-Jen**
**Shanhua Township**
**Taoyuan County 74158 (TW)**
• **Chen, Yi-Jing**
**Shanhua Township**
**Taoyuan County 74158 (TW)**
• **Chung, Hung-Chun**
**Shanhua Township**
**Taoyuan County 74158 (TW)**

(74) Representative: **Winkler, Andreas Fritz Ernst**
**Forrester & Boehmert**
**Pettenkoferstrasse 20-22**
**80336 München (DE)**

Remarks:
Amended claims in accordance with Rule 137(2) EPC.

(54) **Dimmable LED device with low ripple current and driving circuit thereof**

(57) A dimmable light emitting diode (LED) device with low ripple current includes a LED module (140), a phase dimmer (110), a voltage converting module (122,124), a driving module (130) and a feedback module (150). The flyback converter of the voltage converting module adds a secondary forward winding connected to a phase cut-off detector (126) to provide a detecting voltage in proportion to current level of the output current across the LED module.

Fig.2

EP 2 288 028 A1

## Description

Field of the invention

The present invention relates generally to a light emitting diode (LED) device and, more particularly, to a low ripple current dimmable LED device and its driving circuit.

Background of the invention

The light intensity of conventional lamps is mainly controlled by their input current. Therefore, a dimmable lamps based on the conventional technique which was utilizing an AC light dimmer to modulate the phase of input AC voltage then output a phase-modulating AC voltage. Users can use a control device on the AC light dimmer to control the alternating light dimmer, modulate the phase of AC voltage, and enable the phase-modulating AC voltage for dimming brightness or intensity.

The brightness of the lamp is determined by the output phase-modulating AC voltage from the AC light dimmer. If the voltage level becomes lower after modulating the phase of the AC voltage, the light intensity of the lamp will become dimmer; on the contrary, if the voltage level becomes higher, the light intensity of the lamp will become brighter

Nowadays, LED lighting devices has gradually replaced the conventional light bulbs or lamps, the brightness of the LEDs is proportional to their induced current. As a consequence, to adjust the current output from the LED driving device to the LED will regulate the output light intensity. However, the ways of driving conventional light lamps are different from the LED lighting devices. It is not easy for users to regulate the intensity of the LED lighting devices, so the conventional way of using AC light dimmer is not suitable for operating the LED lighting devices.

Typical prior art, phase-modulating LED driver with flyback converter can only allow the usage of input /output capacitors with small capacity for phase-modulating light dimming. The main drawback of the usage of input/output capacitors with small capacity is that the output ripple current will cause the LEDs overheated and shorten their lifetime, even further result an unstable output and led to light flicking.

Accordingly, a modification of the above LED driver circuit remains needed for increasing input/output capacitance and reducing the output ripple current of the LEDs.

Summary of the invention

In accordance with a preferred embodiment of the present invention, there is provided a dimmable LED device with a driver circuit for reducing the output ripple current.

Exemplary embodiments of the present invention disclose a dimmable LED driving circuit for reducing the output ripple current. An exemplary embodiment LED driving circuit comprises: a phase-modulating module, modulating the phase of an AC power to obtain an AC voltage; a voltage-converting module coupled to the phase-modulating module for converting the phase-modulating voltage to a first DC voltage; a driving module coupled to the voltage module for receiving a first DC voltage to drive a LED module and base on the phase-modulating information of the phase dimmer module to control a output current of the LED module; the voltage-converting module includes a flyback converter, the flyback converter includes at least a secondary forward winding to provide a detection voltage as a reference level for the output current of the LED module.

Another exemplary embodiment of the present invention also discloses a dimmable LED device for reducing the output ripple current. In an exemplary embodiment, a dimmable LED device comprises: a LED module; a phase-modulating module, modulating the phase of an AC power to obtain an AC voltage; a voltage-converting module coupled to the phase-modulating module for converting the phase-modulating voltage to a first DC voltage; a driving module coupled to the voltage module for receiving a first DC voltage to drive a LED module and base on the phase-modulating information of the phase dimmer module to control a output current of the LED module; a feedback module, coupled to the driving module and the LED module, to measure the output current and provide the information about the output current for regulating the output current of the LED module; the voltage-converting module includes a flyback converter, the flyback converter includes at least a secondary forward winding to provide a detecting voltage as a reference level across the output current of the LED module.

In an exemplary embodiment, inside the LED device has a secondary forward winding and a phase cut-off detection circuit added for providing an output current reference level which can enable the reduction of output ripple current.

In an exemplary embodiment, the LED lighting device enable the flyback converter with dimmable light intensity ability to increase the output capacity greatly and reduce output ripple current which can stabilize the LED's output light intensity. Therefore, the lifetime of LED can be extended and the degraded of flicker index can also be avoided.

In addition, in an exemplary embodiment, there is no need for applying micro controller unit (MCU) to control the gain of the dimmable light. Therefore, the range of the dimmable light level will be increased, the power consumption also be reduced, and can be matched to the existing dimmer or lighting infrastructure.

In an exemplary embodiment, to utilize the secondary analog control circuit for dimming light, no additional isolation device (such as optocoupler) is needed, which is different from the primary (input) detection technique and can satisfy the need for miniaturization and

simplification.

<u>Brief Description of the Drawings</u>

FIG. 1 is a block diagram of a dimmable light emitting diode (LED) device with low ripple current;
FIG 2 is circuit diagram of a dimmable LED device with low ripple current;
FIG. 3(a)-(d) are the waveforms of the AC input voltage $V_{ac}$ that indicated in FIG. 2;
FIG. 4 is the circuit diagram of the phase cut-off detecting circuit in FIG. 2;
FIG. 5 is the circuit diagram for lowering ripple current of the dimmable LED device;
FIG. 6 is the illustration of the output current $I_{LED}$ of the LED device of the prior art; and
FIG 7 is the output current $I_{LED}$ of the LED device with low ripple current of the present invention.

<u>Description of the symbols of the main elements</u>

100    a LED device;
110    a phase dimmer module;
120    a voltage converting module;
122    a bridge-rectifier;
124    a flyback converter;
126    a phase cut-off detecting unit;
130    a driving module;
132    a power factor correction IC;
140    a LED module;
150    a feedback module;
152    a control unit; and
106    an optocoupler feedback unit.

<u>Detailed Description of the Preferred Embodiment</u>

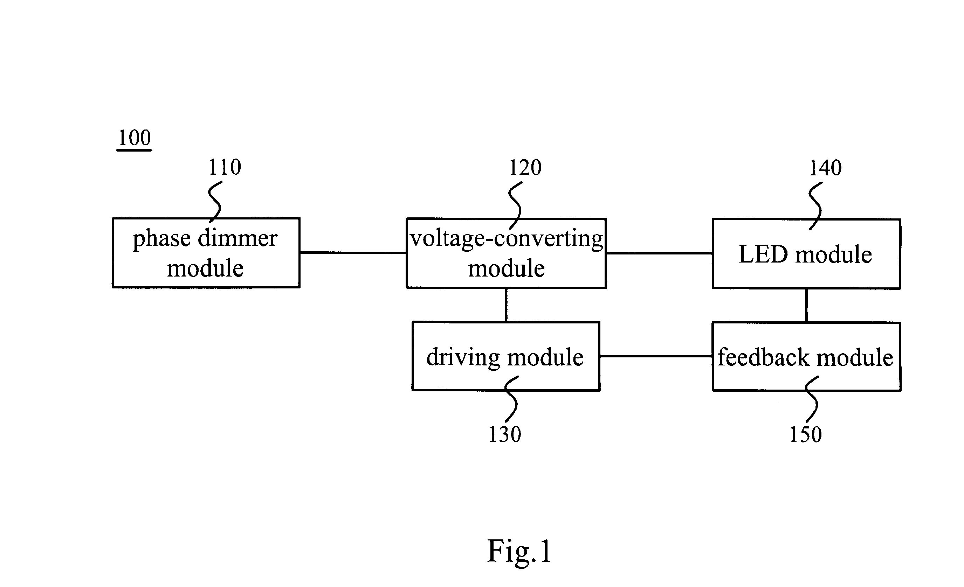

Reference will now be made in detail to embodiments of the present invention, examples of which are illustrated in the accompanying drawings.
In the present invention, a LED driver based on a single stage power factor correction flyback (PFC-Flyback) converter circuit is fabricated. Utilizing line voltage amplitude and waveform to regulate the input current will reduce the phase and waveform distortion between the input current and the in-line voltage and increase the power factor. This will greatly reduce the virtual work dispassion and energy consumptions, therefore obtain the purpose of energy-saving.
As mentioned above, in the present invention, the LED driving circuit is based on the single stage PFC-Flyback converter circuit which is suit for regulating the light intensity on the phase-modulating dimmer of the line voltage. Either the leading or trailing edge of the input voltage signal has been cut-off by the phase dimmer module, the output current of the LED driver will be instantly and in phase cut-off, therefore allowing the opto-output of the LED been reduced with the same ratio.
In the present invention, the driving circuit of the LED device has a secondary forward winding and a phase cut-off detection circuit added on the flyback converter for detecting the phase cut-off period on the dimmer output and regulating the output current reference level in phase. It can increase the output capacity of the single stage PFC-Flyback converter with phase-modulating function and reduce the output ripple current of the LED device.
In the present invention, referring to FIG. 1, it demonstrated a block diagram of a dimmable LED device **100** with low ripple current. The LED device includes a phase dimmer module **110,** a voltage-converting module **120,** a driving module **130,** a LED module **140,** and a feedback module **140.**
After regulating the voltage phase of the line AC power source through the phase dimmer module **110** the AC voltage has been converted into a DC voltage by the voltage-converting module **120.** Converted DC voltage provides the driving force to the driving module **130** and LED module **140** for driving the LED module **140** and regulating the light intensity (output current) of the LED module **140.** In accordance to the phase-modulating information provided by the phase dimmer module **110,** the driving module **130** can control the output current of the LED module through the voltage-converting module **120.** The feedback module **150** can detect the output current of the LED module **140** and provide its output current to the driving module **130** for regulating the output current and maintain a predetermined value.
The phase dimmer module **110,** in an exemplary embodiment, includes an off-line phase dimmer, is used for phase modulating the input AC voltage or current. The voltage -converting module **120** is used for voltage converting, it converted the input voltage to another state (for example convert an AC voltage into DC voltage). In an exemplary embodiment, the voltage-converting module **120** includes a bridge-rectifier and a flyback converter. The voltage-converting module **120** couples to the phase dimmer module **110** converting the phase-modulated AC voltage into same or different level DC voltage. The bridge-rectifier converts the phase-modulated AC voltage into DC voltage then transfer the DC voltage to the LED module through the flyback converter.
The driving module **130** is acted as driver for driving the LED module **140** and control the output current of the LED. The driving module **130** couples to the voltage-converting module **120** and the feedback module **150** receiving the converted DC voltage from the voltage-converting module **120,** based on the phase-modulating information converted the driving module can control the LED module **140.**In an exemplary embodiment, the driving module comprises: a PFCIC and a power switch.. In addition to reducing the dissipation during the voltage converting and increasing the power factor of the circuit, the PFCIC can also provide a on-off signal to the power switch to drive the LED module. The power switch is based on the on-off signal to control the voltage converting frequency of the flyback converter inside the voltage converter **120** to control the LED module **140.**

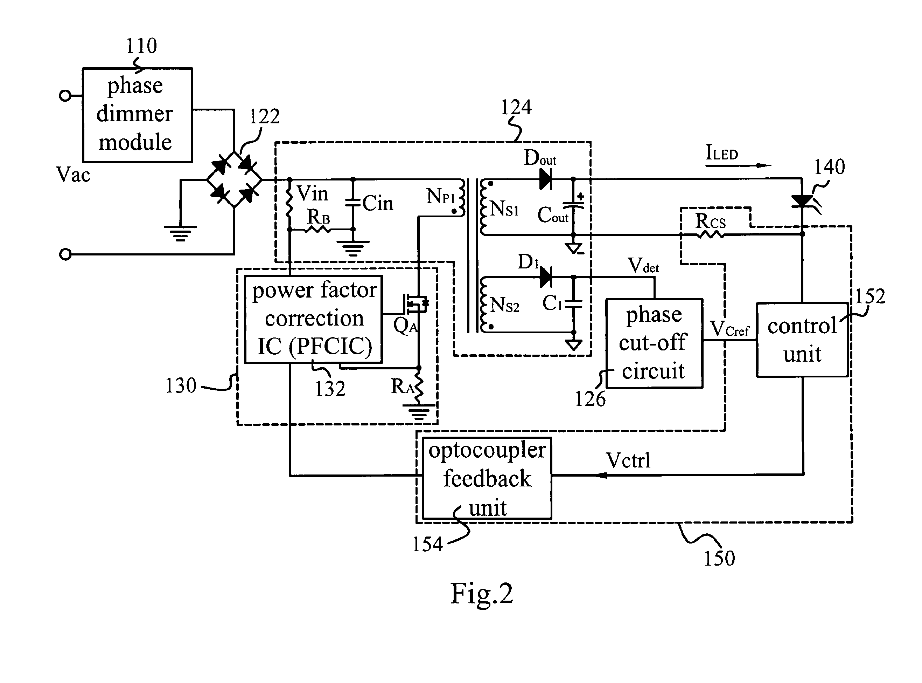

The feedback module **150** is utilized to provide the information of the output current of the LED **140** into the driving module **130.** The driving module **130** can regulate the output voltage of the LED **140,** based on the information of the feedback output current, and maintain the predetermined value. In an exemplary embodiment, the feedback module **150** includes a feedback resistor, a control unit, and a optocoupler feedback unit. The feedback resistor couples to the LED module **140** for detecting the output current of the LED module **140.** The control unit **152,** based on the output current information that provided by the feedback resistor, transmits the control signal to the optocoupler feedback unit. The control signal is converting into a optical signal through the optocoupler feedback unit and transmits into the driving module **130.** The circuit is shown in FIG. 2.

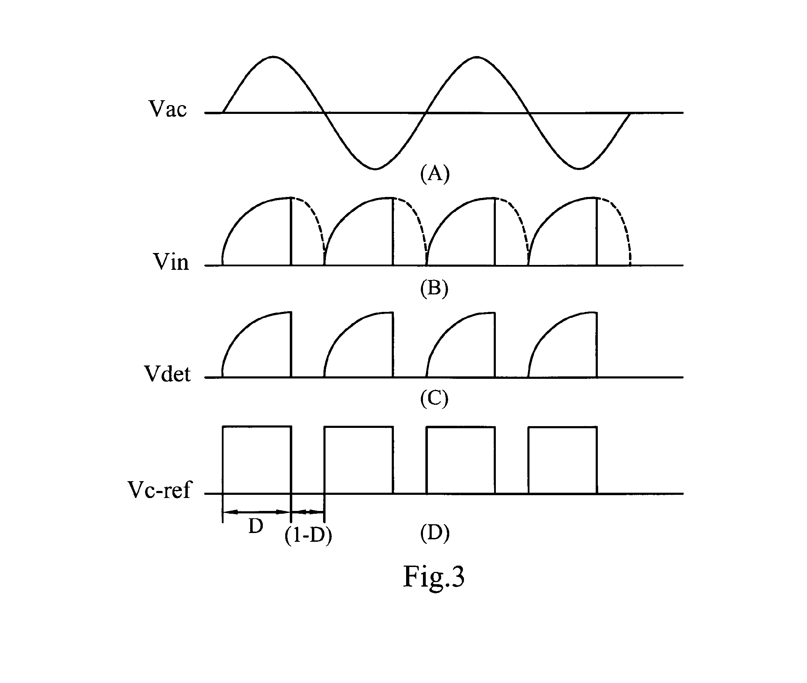

In an exemplary embodiment, FIG. 2 showed the circuit of dimmable LED device **100** with low ripple current. The in-line power supply provides an AC voltage $V_{ac}$ (as shown in FIG. 3(A)) to the phase-dimmer module **110** and will modulate an phase-modulating AC voltage.

The voltage- converting module **120** includes a bridge-rectifier **122,** a flyback converter **124,** and a phase-detecting cut-off circuit **126.** The bridge-rectifier is located between the phase-dimmer **110** and the flyback converter **124,** the AC voltage go through phase-modulating process, has been cut-off by part of the phase by the phase-dimmer **110,** and transmit to the bridge-rectifier **122** for rectifying into a first DC current $V_{in}$ (as shown in FIG. 3(B)).

The flyback converter **140** connects to the bridge-rectifier **122** which is receiving the first DC current $V_{in}$ and transforming into a second DC current and output into the LED module **140.** The flyback converter includes a primary forward winding $N_{p1}$, a secondary forward winding, and a secondary reverse winding $N_{S2}$. Diodes $D_{out}$ $D_1$ and capacitors $C_{in}$, $C_{out,}$ and $C_1$ are used for filtering and rectifying signals. The primary forward winding $N_{P1}$ is magnetic coupled to the secondary forward winding $N_{S1}$ and the secondary reverse winding $N_{S2}$. The flyback converter **124** receives the first DC voltage $V_{in}$ through the primary forward winding $N_{S1}$ and converts the level of the first DC voltage into a second DC voltage and output the second DC voltage to the secondary forward winding $N_{S1}$.

The diode $D_{out}$ has been reversed cut-off while the primary forward winding $N_{P1}$ conducting, therefore no voltage output into the LED module **140.** The primary forward winding will provide a reverse potential to the secondary reverse winding $N_{S1}$ and the LED module **140** while the primary forward winding being cut-off.

The secondary forward winding $N_{S2}$ coupled to a phase cut-off detecting circuit **126.** When the primary and the secondary winding of the transformer has Np1 and Ns2 winding loops, respectively. According to the principle of transformer, the detected voltage of the secondary forward winding $N_{S2}$ (FIG.3) can be expressed as

$$V_{det} = V_{in}*Ns2/Np1;$$

The detected voltage $V_{det}$ will produce a reference voltage $V_{c-ref}$ (as shown in FIG. 3 (D)) after being processed by the phase cut-off detecting circuit **126,** this is acted as a reference level of the output current $I_{LED}$ of the LED module **130.** In referring to FIG. 3(D), the level of reference voltage $V_{c-ref}$ is IHL while the conducting period is D (D≤1); the level of reference voltage $V_{c-ref}$ is ILL while the conducting period is 1-D. Therefore, the output current $I_{LED}$ of the LED module **140** can be regulated by the voltage conducting angle ratio and the purpose of dimming light intensity can be obtained. The output current $I_{LED}$ of the LED module can be calculated by the formula

$$I_{LED} = IHL*D + ILL*(1-D).$$

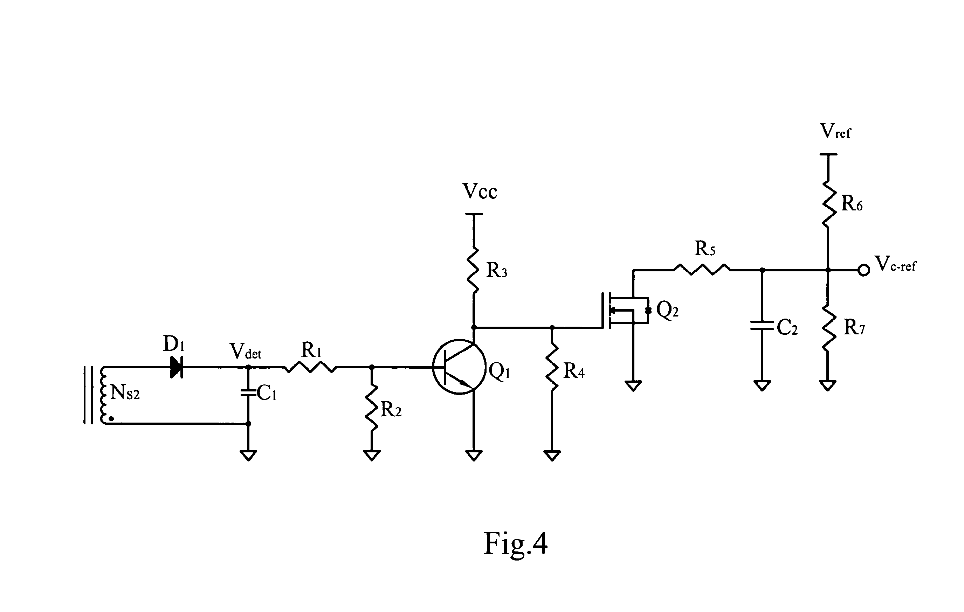

Referring to FIG. 4, in an exemplary embodiment, is circuit diagram of the phase cut-off detecting circuit **126.** A first end of a first resistor $R_1$ connects to a diode $D_1$ and a capacitor $C_1$, a second end of the first resistor connects to the first end of a second resistor $R_2$. A second end of the second resistor connects to the ground. The base of a first transistor $Q_1$ connects to the first end of the second resistor $R_2$ and the emitter of the first transistor $Q_1$ connects to the ground. A first end of the third resistor $R_3$ connects to a first power supply $V_{cc}$ and a second end of the third resistor $R_3$ connects to the collector of the first transistor $Q_1$. A first end of the fourth resistor $R_4$ connects to the collector of the first transistor $Q_1$ and the second end of the third resistor $R_3$, the second end of the fourth resistor $R_4$ connects to the ground. The gate of the second transistor $Q_2$ connects to the first end of the fourth resistor $R_4$, the source of the second transistor $Q_2$ connects to the ground. The first end of the fifth resistor $R_5$ connects to the drain of the second transistor $Q_2$, the second end of the fifth resistor connects to the output of the phase cut-off detecting circuit **126.** The first den of the second capacitor $C_2$ connects to the second end and the output of the phase cut-off detecting circuit **126,** the second of the second capacitor connects to the ground. The first end of the sixth resistor $R_6$ connects to a second power supply $V_{ref}$, the second end of the sixth resistor connects to the output of the phase cut-off detecting circuit **126.** The first end of the seventh resistor $R_7$ connects to the output of the phase cut-off detecting circuit **126** and the second end of the seventh resistor $R_7$ connects to the ground.

The phase cut-off detecting circuit **126** connects to the secondary winding $N_{S2}$. The detecting voltage $V_{det}$ of the secondary winding $N_{S2}$, filtering and rectifying by the diode $D_1$ and the capacitor, can equal-ratio sampling the waveform of the first DC voltage coming from the primary forward winding. After voltage divided by the resistors $R_1$ and $R_2$, the $V_{det}$ input into the gate of the first transistor $Q_1$. If the voltage of $R_2$ small than the gate voltage $V_{BEO}$ (about 0.6 volt), then the transistor $Q_1$ is conducting and the transistor $Q_2$ is cut-off. This will lower the output reference voltage of the phase cut-off detecting circuit **126**. Therefore, the current level that output to $I_{LED}$ will also lower with equal-ratio and reduce the ripple components of the output current $I_{LED}$ efficiently.

The power factor correction integrated circuit (PFCIC) **132** coupled to the bridge-rectifier **122** for increasing the efficiency during the voltage converting process and the power factor of the voltage converting module **120**. The power switch $Q_A$ connects between the flyback converter **124,** the primary forward winding $N_{P1}$, and the PFCIC **132,** the PFCIC **132** transmits the on-off signals to the power switch $Q_A$ to control the flyback converter **124** and the output current $I_{LED}$ of the LED **140**.

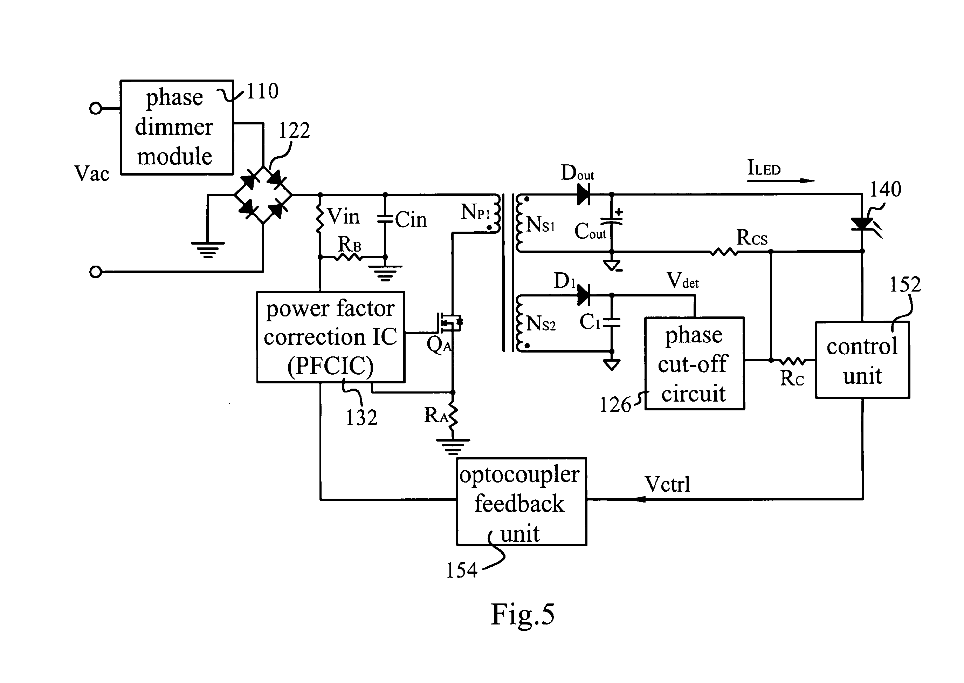

The feedback resistor $R_{cs}$ connects to the LED module **140** to detect the output current $I_{LED}$ of the LED module **140** and produce a feedback voltage for regulating the value of the output current $I_{LED}$ in a predetermined range. The control unit **152** connects to the feedback resistor $R_{cs}$, LED module **140,** the phase cut-off detecting circuit **126,** and the optocoupler feedback unit **154.** Based on the feedback voltage provided by the feedback resistor Rcs and the reference voltage provided by the phase cut-off detecting circuit, the control unit **152** produces a control signal Vcrtl to regulate the output current $I_{LED}$. The optocoupler feedback unit **152** receives the control signal $V_{ctrl}$ from the control unit and converts into optical signal then send it into the PFCIC **132**. In an exemplary embodiment, the output of the phase cut-off detecting circuit **126** can also connect to feedback resistor $R_{cs}$, as shown in FIG. 5.

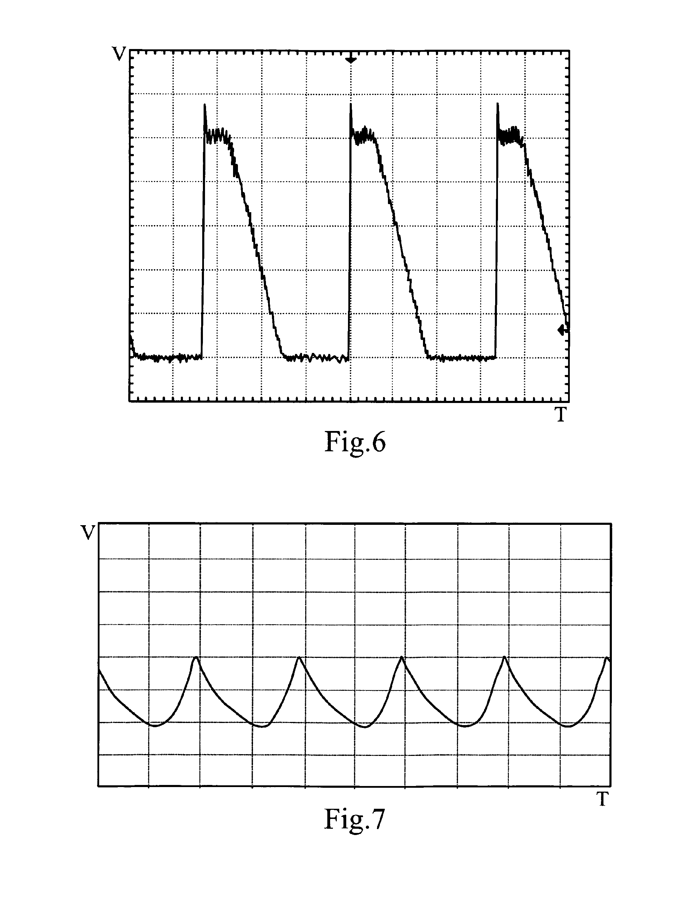

In the present invention, adding a secondary forward winding and a phase cut-off detecting circuit on the transformer of the single stage high power factor flyback converter can enlarge the value of the output capacitor, connects to the LED module, to about several Farads. This will lower the current that outputs to the LED. By comparing the prior arts, FIG. 6, and the present invention, FIG. 7, the ripple current of the LED device is about $\pm$ 100% during 90 degree light dimming in the prior arts while in the present invention ripple current has been lowered to about $\pm$ 40%. In addition to that, the output ripple current can be lowered by adjusting the output capacity which can be done based on the real situation.

It will be apparent to those skilled in the art that various modifications and variation can be made in the present invention without departing from the spirit or scope of the invention. Thus, it is intended that the present invention provided they come within the scope of the appended claims and their equivalents.

**Claims**

1. A driving circuit for a dimmable light emitting diode (LED) device with low ripple current comprises:

   a phase dimmer and a phase-modulating module for obtaining a phase-modulating AC voltage;
   a voltage-converting module coupled to the phase-modulating module for converting the AC voltage to a first DC voltage;
   a driving module coupled to the voltage-converting module for receiving the first DC voltage and driving the LED module, controlling one of the output current of the LED module based on the phase-modulating information of the phase-modulting module; and
   the voltage-converting module includes at least a secondary forward winding providing a detecting voltage as a reference of the output current of the LED module.

2. A driving circuit for a dimmable light emitting diode (LED) device with low ripple current of claim 1, wherein the voltage-converting module includes a phase cut-off detecting circuit coupled to at lease a secondary forward winding providing a detecting voltage as a reference of the output current of the LED module.

3. A driving circuit for a dimmable light emitting diode (LED) device with low ripple current of claim 2, wherein the phase cut-off detecting circuit comprises:

   a first resistor;
   a second resistor, a first end of the second resistor connects to the first resistor, a second of the second resistor connects to a ground;
   a first transistor, the base of the transistor connect to the first end of the second resistor, the emitter of the first transistor connects to the ground;
   a third resistor, a first end of the third resistor connects to a first supply voltage, a second end of the third resistor connects to the collector of the first transistor;
   a fourth resistor, a first end of the fourth resistor connects to the collector of the first resistor and the second end of the third resistor, a second end of the fourth resistor connects to the ground;
   a second transistor, the gate of the second transistor connects to the first end of the fourth resistor, the source of the second transistor connects to the ground;
   a fifth resistor, a first end of the fifth resistor connects to the drain of the second transistor, a second end of the fifth resistor connects to the output of the phase cut-off detecting circuit;

a second capacitor, a first end of the second capacitor connects to the second of the fifth resistor and the output of the phase cut-off detecting circuit, a second end of the second capacitor connects to the ground;

a sixth resistor, a first end of the sixth resistor connects to a second supply voltage,

a second end of the sixth resistor connects to the output of the phase cut-off detecting circuit; and

a seventh resistor, a first end of the seventh resistor connects to output of the phase cut-off detecting circuit, a second of the seventh resistor connects to the ground.

4. A driving circuit for a dimmable light emitting diode (LED) device with low ripple current of claim 1, wherein the driving circuit includes a feedback module coupled to the driving module and the LED module for detecting the output current and providing the output current information to the driving module and regulates the output current of the LED module;

5. A driving circuit for a dimmable light emitting diode (LED) device with low ripple current of claim 4, wherein the feedback module comprises:

a feedback resistor coupled to the LED module for producing a feedback voltage;

a control unit coupled to the feedback resistor and the LED module, based on the feedback voltage and the reference level, produces a control signal to regulating the output current of the LED module; and

an optocoupler feedback unit coupled to the control unit, receiving the control signal and converting into the control signal into optical signal, providing the optical signal to the driving module.

6. A driving circuit for a dimmable light emitting diode (LED) device with low ripple current of claim 5, wherein the feedback resistor coupled to between the phase cut-off circuit and the control circuit for regulating the output current of the LED module.

7. A driving circuit for a dimmable light emitting diode (LED) device with low ripple current of claim 1, wherein the phase-dimmer module includes an off-line phase dimmer.

8. A driving circuit for a dimmable light emitting diode (LED) device with low ripple current of claim 1, wherein the voltage-converting module includes a bridge-rectifier coupled to the phase-dimmer module and the flyback converter for converting the phase-modulating AC voltage into the first DC voltage.

9. A driving circuit for a dimmable light emitting diode (LED) device with low ripple current of claim 1, wherein the flyback converter converts the level of the first DC voltage and output a second DC voltage to the LED module.

10. A driving circuit for a dimmable light emitting diode (LED) device with low ripple current of claim 9, wherein the flyback converte comprises:

a primary forward winding receives the first DC voltage for converting the level of the first DC voltage and output the second DC voltage into the secondary side of the flyback converter; and

a secondary reversing winding magnetic coupled to the primary forward winding for producing the second DC voltage.

11. A driving circuit for a dimmable light emitting diode (LED) device with low ripple current of claim 1, wherein the driving module includes a power factor correction IC (PFCIC) coupled to the voltage-converting module for increasing the power factor of the voltage-converting module and also provides a on-off signal for driving the LED module; and a power switch coupled to the flyback converter, based on the signal provided from the PFCIC for driving the LED module.

**Amended claims in accordance with Rule 137(2) EPC.**

1. A driving circuit for a dimmable light emitting diode (LED) device with low ripple current comprises:

a phase dimmer module (110) for obtaining a phase-modulating AC voltage;

a voltage-converting module (120) coupled to the phase dimmer module (110) for converting the phase-modulating AC voltage to a first DC voltage;

a driving module (130) coupled to the voltage-converting module (120) for receiving the first DC voltage and driving LED module (140), controlling one of the output current of the LED module based on the phase-modulating information of the phase dimmer module (110); wherein the voltage-converting module (120) includes at least a secondary forward winding providing a detecting voltage as a reference of the output current of the LED module, and

a phase cut-off detecting circuit (126) coupled to the secondary forward winding providing a detecting voltage as a reference of the output current of the LED module (140).

2. A driving circuit for a dimmable light emitting diode (LED) device with low ripple current of claim, wherein the phase cut-off detecting circuit (126) comprises:

a first resistor;
a second resistor, a first end of the second resistor connects to the first resistor, a second end of the second resistor connects to a ground;
a first transistor, the base of the transistor connect to the first end of the second resistor, the emitter of the first transistor connects to the ground;
a third resistor, a first end of the third resistor connects to a first supply voltage, a second end of the third resistor connects to the collector of the first transistor;
a fourth resistor, a first end of the fourth resistor connects to the collector of the first resistor and the second end of the third resistor, a second end of the fourth resistor connects to the ground;
a second transistor, the gate of the second transistor connects to the first end of the fourth resistor, the source of the second transistor connects to the ground;
a fifth resistor, a first end of the fifth resistor connects to the drain of the second transistor, a second end of the fifth resistor connects to the output of the phase cut-off detecting circuit;
a second capacitor, a first end of the second capacitor connects to the second of the fifth resistor and the output of the phase cut-off detecting circuit, a second end of the second capacitor connects to the ground;
a sixth resistor, a first end of the sixth resistor connects to a second supply voltage, a second end of the sixth resistor connects to the output of the phase cut-off detecting circuit; and
a seventh resistor, a first end of the seventh resistor connects to output of the phase cut-off detecting circuit, a second of the seventh resistor connects to the ground

**3.** A driving circuit for a dimmable light emitting diode (LED) device with low ripple current of claim 1, wherein the driving circuit (130) includes a feedback module (150) coupled to the driving module (130) and the LED module (140) for detecting the output current and providing the output current information to the driving module (130) and regulates the output current of the LED module (140).

**4.** A driving circuit for a dimmable light emitting diode (LED) device with low ripple current of claim 4, wherein the feedback module (150) comprises:

a feedback resistor coupled to the LED module (140) for producing a feedback voltage;
a control unit (152) coupled to the feedback resistor and the LED module (140), based on the feedback voltage and the reference level, produces a control signal to regulation the output current of the LED module (140); and
an optocoupler feedback unit (154) coupled to the control unit (152), receiving the control signal and converting into the control signal into optical signal, providing the optical signal to the driving module (130).

**5.** A driving circuit for a dimmable light emitting diode (LED) device with low ripple current of claim 4, wherein the feedback resistor coupled to the phase cut-off detecting circuit (126) and the control unit (152)for regulating the output current of the LED module (140).

**6.** A driving circuit for a dimmable light emitting diode (LED) device with low ripple current of claim 1, wherein the phase-dimmer module (110) includes an off-line phase dimmer

**7.** A driving circuit for a dimmable light emitting diode (LED) device with low ripple current of claim 1, wherein the voltage-converting module (120) includes a bridge-rectifier (122) coupled to the phase dimmer module (110) and flyback converter (124) for converting the phase-modulating AC voltage into the first DC voltage.

**8.** A driving circuit for a dimmable light emitting diode (LED) device with low ripple current of claim 7, wherein the flyback converter (124) converts the level of the first DC voltage and output a second DC voltage to the LED module (140).

**9.** A driving circuit for a dimmable light emitting diode (LED) device with low ripple current of claim 8, wherein the flyback converter (124) comprises:

a primary forward winding receives the first DC voltage for converting the level of the first DC voltage and output the second DC voltage into the secondary side of the flyback converter (124); and
a secondary reversing winding magnetic coupled to the primary forward winding for producing the second DC voltage.

**10.** A driving circuit for a dimmable light emitting diode (LED) device with low ripple current of claim 1, wherein the driving module (130) includes a power factor correction IC (PFCIC) (132) coupled to the voltage-converting module (120) for increasing the power factor of the voltage-converting module (120) and also provides a on-off signal for driving the LED module (140); and a power switch coupled to the flyback converter (124), based on the signal provided from the PFCIC (132) for driving the LED module (140).

100

110

120

140

| phase dimmer module | | voltage-converting module | | LED module |

driving module — feedback module

130

150

EP 2 288 028 A1

Fig.1

Fig.2

EP 2 288 028 A1

Fig.3

Fig.4

Fig.5

EP 2 288 028 A1

Fig.6

Fig.7

Europäisches
Patentamt

European
Patent Office

Office européen
des brevets

# EUROPEAN SEARCH REPORT

Application Number

EP 09 01 0214

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/115058 A (POLYBRITE INTERNATIONAL INC [US]; SCIANNA CARLO [US]) 1 December 2005 (2005-12-01) | 1,4,7-10 | INV. H03K17/16 H05B33/08 |
| A | * paragraphs [0010], [0011], [0014] * * paragraphs [0034] - [0036]; figure 8 * ----- | 2 | |
| X | US 2008/278092 A1 (LYS IHOR [US] ET AL) 13 November 2008 (2008-11-13) * paragraphs [0048], [0081]; figure 12 * * paragraph [0086]; figure 12A * ----- | 1,7-11 | |
| X | WO 02/096162 A (KONINKL PHILIPS ELECTRONICS NV [NL]) 28 November 2002 (2002-11-28) * page 3, line 16 - page 4, line 23; figure 3 * ----- | 1,4,5, 7-11 | |
| X | US 2007/267984 A1 (PENG CHRIS [US]) 22 November 2007 (2007-11-22) * paragraph [0038]; figures 1,2A * * paragraph [0040]; figures 2B-2D * * paragraphs [0041] - [0045]; figure 3 * ----- | 1,4,7-10 | TECHNICAL FIELDS SEARCHED (IPC) H03K H05B |

The present search report has been drawn up for all claims

| Place of search | Date of completion of the search | Examiner |
|---|---|---|
| Munich | 6 November 2009 | Martínez Martínez, J |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 09 01 0214

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2009

| Patent document cited in search report | | Publication date | Patent family member(s) | | Publication date |
|---|---|---|---|---|---|
| WO 2005115058 | A | 01-12-2005 | AU | 2005246918 A1 | 01-12-2005 |
| | | | CA | 2536307 A1 | 01-12-2005 |
| | | | CN | 1843061 A | 04-10-2006 |
| | | | EP | 1752022 A1 | 14-02-2007 |
| | | | JP | 2007538378 T | 27-12-2007 |
| | | | MX | PA06005602 A | 17-08-2006 |
| | | | NZ | 545325 A | 29-08-2008 |
| | | | US | 2008258647 A1 | 23-10-2008 |
| US 2008278092 | A1 | 13-11-2008 | WO | 2008137460 A2 | 13-11-2008 |
| WO 02096162 | A | 28-11-2002 | CN | 1463566 A | 24-12-2003 |
| | | | EP | 1396176 A1 | 10-03-2004 |
| | | | JP | 2004527138 T | 02-09-2004 |
| | | | US | 2002176262 A1 | 28-11-2002 |
| US 2007267984 | A1 | 22-11-2007 | NONE | | |

EPO FORM P0459

For more details about this annex : see Official Journal of the European Patent Office, No. 12/82